# EUROPEAN PATENT SPECIFICATION

(11) **EP 1 797 746 B1**
(45) Date of publication and mention of the grant of the patent: **08.12.2010**
(21) Application number: 05791477.2
(22) Date of filing: 03.10.2005
(51) Int. Cl.: H05H 1/30, H01J 37/32

(54) **MICROWAVE PLASMA APPARATUS WITH VORTICULAR GAS FLOW**
MIKROWELLENPLASMAVORRICHTUNG MIT STRUDELFÖRMIGEM GASFLUSS
APPAREIL A PLASMA A MICRO-ONDES

(30) Priority: 04.10.2004 GB 0421998
(43) Date of publication of application: 20.06.2007
(73) Proprietor: C-Tech Innovation Limited, Capenhurst, Chester CH1 6EH (GB)
(72) Inventor: WRIGHT, Neil Philip, Bebington, Wirral, Merseyside CH63 3DS (GB); DUAN, Xiaoming, COLCHESTER, Essex CO3 3UF (GB); PHAN, Ba, Duong, Westminster, California 92683 (US)
(74) Representative: Frost, Alex John
(86) International application number: PCT/GB2005/003811
(87) International publication number: WO 2006/037991

(56) References cited:
- EP-A- 0 397 468
- DE-B- 1 205 209
- FR-A- 2 066 220
- GB-A- 1 202 587
- US-A- 5 874 705

## Description

The present invention relates to a method of and apparatus for producing a microwave plasma jet, particularly but not exclusively at atmospheric pressure.

Microwave generated plasmas are used in a wide range of different applications. A first type of plasma generator is used as a so-called API (atmospheric pressure ioniser) source in which sample material is injected in ionised form into a mass spectrometer, for spectroscopic analysis. This type of generator employs relatively sophisticated equipment with a small microwave chamber acting as a monomodal microwave cavity, adapted to very low levels of sample material. The dimensions and microwave energy mean that maintaining a plasma is relatively straightforward, although degradation may occur over time.

A separate branch of microwave plasma technology addresses such applications as the synthesis of new materials, waste gas processing and materials surface engineering. Such microwave plasma apparatuses typically have a large volume chamber adapted to accept high volumes of plasma gas for essentially industrial scale processing. For example, US-A-5,782,085 discloses a microwave plasma apparatus for removing nitrogen oxides from internal combustion engine exhaust gases.

WO 96/02934 shows a microwave plasma apparatus of the latter, relatively high volume type. As explained in this document, with such a relatively large microwave chamber, the operation of the apparatus at atmospheric pressure (which is desirable) whilst maintaining a plasma therein is not straightforward. A partial solution is proposed by the arrangement of WO-A-96/02934, in which the struck plasma is contained within a confinement vessel in the apparatus and the microwave power to the vessel is then controlled. Nevertheless, this arrangement does still suffer from potential instability of the plasma, particularly at low flow rates. This instability may cause the plasma to stick to one side of the reaction tube. In the case of silica glass, if the plasma touches the glass even for a few seconds, it may result in the glass melting and the destruction of the system.

A further problem which has been encountered is that, after the plasma has been generated, the plasma itself may 'stick' to the container walls, causing the latter to increase in temperature. This increase may cause the absorption of microwaves by the container walls, resulting in a loss of plasma maintenance. EP0397468 discloses a microwave plasma torch comprising a housing and a discharge tube therein. A microwave source radiates energy via a coupling loop antenna into the housing and into the discharge tube. A fluid inlet member that is in fluid communication with the discharge tube is located upstream of the housing and the discharge tube. It contains six helical grooves that alter the direction of the gas flow such that a vorticular gas flow is formed within discharge the discharge tube.

The object of the present invention is to provide a stable plasma, generated at atmospheric pressure, and suitable for processing relatively high volumes of plasma and sample materials.

According to a first aspect of the present invention, there is provided a microwave plasma apparatus comprising: a microwave chamber for containing gas and a plasma once initiated, the chamber having an inlet and an outlet; means for radiating microwave energy into said chamber to produce a plasma therein, the microwave chamber and the means for radiating microwave energy being adapted so as to establish a non-resonant, multimode microwave cavity; means for initiating said plasma; and a fluid inlet member upstream of the microwave chamber inlet and in fluid communication therewith, the fluid inlet member being adapted to alter the direction of flow of a received supply of gas so as to introduce the gas into the microwave chamber via the inlet thereof as a vorticular or swirled flow.

The use of a non-resonant, multimode cavity results in a relatively "untuned" device which in turn allows the plasma to adapt readily to changes in process conditions and vessel shapes. The use of a fluid inlet member which introduces vorticular or swirled flow to a gas which will establish the plasma provides a significantly more energy-efficient stable and controllable microwave plasma apparatus. Moreover, the position of the plasma is better constrained. The flow rate can likewise be increased; plasma gas flow rates of up to 200 litres/minute can be employed although, typically, rates of 10 to 20 litres/minute and no more than 40 litres/minute are currently preferred. Indeed, a further advantage of the arrangement of the present invention is that it permits stable and controllable low flow rates to be sustained.

In preference, the cavity is relatively large; for example the cavity length may be of the same order as the wavelength of the microwaves.

Whilst the apparatus is particularly suitable for operation at atmospheric pressure, it is possible to operate it at lower or higher pressures for certain applications.

Preferably, the fluid inlet member comprises one or more conduits arranged to receive the supply of gas, and a curved section passage in communication with the microwave chamber inlet, the or each conduit having a longitudinal axis which is substantially perpendicular to a radius of the said curved section passage. The gas thus flows in through the conduits and is wrapped around the walls of the curved section passage to create the vorticular flow.

Preferably, the or each conduit causes the gas to flow in a generally downward direction into the curved section passage. The longitudinal axis of the or each conduit preferably intersects a plane orthogonal to the longitudinal axis of the curved section passage at an angle between about 0° and about 30°, and preferably at 15°. Thus the conduits force the gas into the curved section passage (which preferably forms a part of the microwave chamber), and from there into the main body of the microwave chamber, in a generally downward direction.

Of course, by "downward", it is simply meant that the gas flows towards the exit. In the typical arrangement, this is vertically below the inlet, but it is to be understood that the device may be operated at any arbitrary orientation. Thus, the chamber may for example be mounted upside down, or horizontally, so that the inlet is then, strictly, above the exit or horizontally in line with it, respectively. The word "downward" is thus to be understood in this context.

Preferably, the microwave chamber further includes a vessel arranged to confine the plasma within a volume which is less than the total volume of the said microwave chamber. In that case, the curved section passage and the vessel may each be substantially right-cylindrical. The curved section passage is preferably substantially coaxial with the vessel and chamber inlet, with the curved section passage and the inlet each being slightly larger in diameter than the diameter of the vessel. The vessel may be formed of a refractory material such as quartz. Preferably, the microwave chamber outlet is defined by a nozzle adapted to cause plasma gas to exit therethrough as a jet. In the alternative, the chamber outlet may not be throttled and a full diameter outlet may instead be desirable, for example for high flow VOC treatment and/or to increase the area of coverage.

In an alternative embodiment, the vessel may have a waist portion so as to form an 'egg-timer' shape. This shape is particularly beneficial at low flow rate as it acts to prevent vessel overheating.

The apparatus may further comprise a mixing chamber located downstream of the microwave chamber and in fluid communication therewith, the mixing chamber being arranged to receive plasma gas from the microwave chamber via the outlet thereof. The mixing chamber may then further comprise a reactant inlet for introduction of reactant material into the said mixing chamber.

The generally downward and spiral or vorticular flow of plasma gas into the mixing chamber is advantageous in that it prevents back flow of reactant material up the microwave chamber. Instead, any reactant material is forced in a generally downward direction by the flow of the plasma gas.

The means for radiating the microwave energy into the chamber is preferably a variable power magnetron capable of generating up to 5kW of power (although other magnetrons capable of generating higher power outputs may be employed in certain cases). The volume in which the plasma is generated is typically around 800cm³, although larger and smaller volumes are possible. The referred frequency is 2,45 GHz but the apparatus may also be operated at, for example, 896 MHz. In principle, other frequencies may be employed.

In accordance with a second aspect of the present invention, there is provided a method of generating a plasma in a microwave plasma apparatus comprising: introducing swirled or vorticular movement to a flow of gas; supplying the said vorticularly moving gas to a microwave chamber of the microwave plasma apparatus; and radiating microwave energy into the chamber so as to establish a non-resonant, multimode microwave cavity in which a plasma is produced.

Further advantageous features are set out in the claims appended hereto.

The invention may be put into practice in a number of ways, and one will now be described by way of example only and with reference to the following drawings, in which:
Figure 1 shows, schematically, a side-sectional view of a microwave plasma apparatus in accordance with an embodiment of the invention; and
Figure 2 shows a plan view of the upper part of the microwave plasma apparatus of Figure 1.

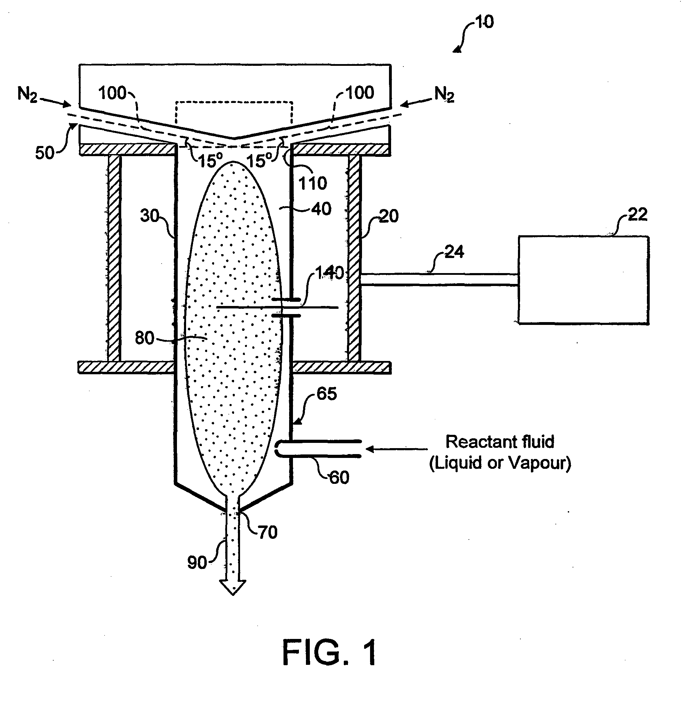

Referring first to Figure 1, a plasma generating apparatus 10 is shown. The apparatus 10 includes a microwave cavity 20 which is coupled to a microwave source 22 by a wave guide 24. The microwave source is, in preference capable of producing a range of power outputs and frequencies up to 5 kW and 2.45 Ghz respectively; although typically the maximum available frequency (2.45 Ghz) is preferred, lower frequencies (such as 896 MHz) may be used instead. Moreover, whilst a continuous microwave source is described in the following, it is to be understood that a pulsed source is equally feasible.

Within the microwave cavity 20 is a reaction tube 30 which defines a plasma cavity 40. The reaction tube 30 is preferably formed from a refractory material such as quartz. At the upper end of the reaction tube 30, as seen in Figure 1, a gas inlet member 50 is provided. The preferred configuration of this manifold, and its purpose, will be described in further detail below.

Although, in Figure 1 it will be seen that the reaction tube 30 is in preference right cylindrical, it will be understood that other shapes are contemplated. For example, a waisted "egg-timer" shape may be suitable for some applications.

The reaction tube 30 opens into a mixing zone 65 which is beneath the microwave cavity 20. A feedstock injection port 60 opens into the mixing zone 65 and allows injection of a reactant fluid in liquid or vapour form. It is, however, to be understood that the reactant fluid can be supplied instead further up the reaction tube 30 and indeed as a mixture along with the plasma gas via the gas inlet member 50.

The mixing zone 65 has an opening opposite the input to the mixing zone from the microwave cavity 20, which is defined by an exit nozzle 70. The system is electrodeless and a plasma is initiated with a graphite rod 140 within the microwave chamber 20. Once the plasma has been struck, the graphite rod 140 is withdrawn as it is not required to maintain the plasma, which is sustained by the collision of electrons which have been accelerated by the microwave field with the other (larger) species present (and with each other), leading to raised temperatures. The diffuse, glowing plasma 80 is homogeneous and its shape can be changed according to the reaction tube 30. The volume of the plasma (which is determined by a number of factors including flow nozzle size, plasma chamber size and shape, and gas type) can be controlled by adjustment of the input power.

Although the microwave cavity 20 and mixing zone 65 have been described as separate components, it will be understood (and may be seen even from the schematic diagram of Figure 1) that the mixing zone 65 is in fact a smooth, continuous extension to the microwave cavity 20, and that microwaves will in fact be present in the mixing zone 65 as well.

A range of dimensions may be employed for the apparatus 10. However, in preference, the reaction tube 30 has a diameter of around 8cm. The diameter of the microwave chamber 20 is preferably around 16cm, and the chamber 20 is also around 16cm in length. The mixing zone 65 is around 10cm in length but can be shorter or significantly longer, to permit advantageous variations in processing conditions.

Coupled with the variable 5kW microwave source, the microwave cavity 20 acts as a multimode microwave cavity. This is preferable to a tuned cavity or waveguide which does not produce a uniform field. Moreover, the microwave cavity 20 provides a more diffuse, less intense plasma. This provides a more chemically rich mix of activating species, makes it more manageable, and provides a larger volume. The plasma extinguish time in the cavity 20 is less than 10ms.

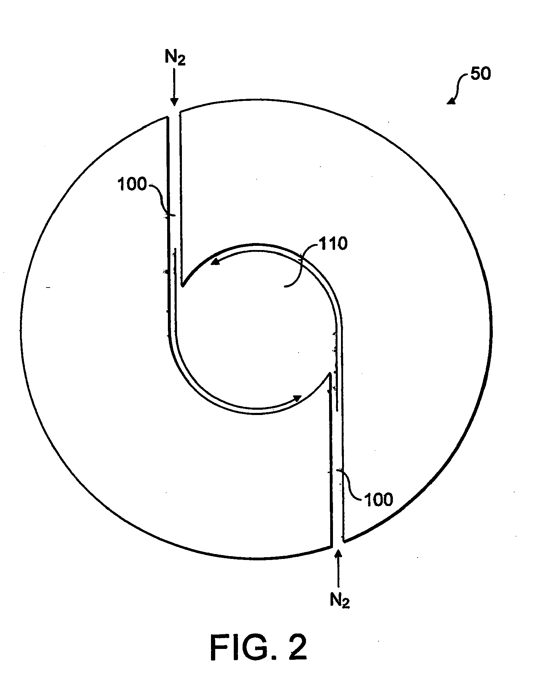

In operation, a small amount of plasma-forming gas (in the described embodiment, this is typically nitrogen or argon) is introduced into the reaction tube 30 via the gas inlet member 50. This gas inlet member 50 is shown in plan view in Figure 2 and contains a central, generally cylindrical bore 110. As seen from Figure 1, this cylindrical bore 110 is coaxial with the longitudinal bore of the reaction tube 30, the mixing zone 65 and the nozzle 70. In preference, the diameter of the central bore 110 of the gas inlet member 50 is slightly larger than the diameter of the reaction tube 30 and the mixing zone 65.

In the illustrated embodiment of Figure 2, plasma gas is supplied to the reaction tube 30 and the microwave cavity 20 by two opposed gas inlets 100. These gas inlets open into the central bore 110 of the gas inlet member 50 at a tangent as best seen in Figure 2. The longitudinal axes of the gas inlets 100 are also canted downwards at an angle of around 105° to the longitudinal axis of the microwave cavity 20 and reaction tube 30 in particular. Because the plasma gas is fed into the central bore 110 tangentially, it is wrapped around in a generally circular direction so that the gas as injected into the reaction tube 30 is likewise swirling around. The downward cant of the inlets 100 introduces a downward component to the flow of the plasma gas so that the resultant gas flow into the microwave cavity is in the form of a vortex.

This vorticular flow of plasma gas prevents the silica reaction tube 30 from overheating, particularly at low flow rates; overheating leads to the reaction tube 30 becoming absorbent to microwave energy which in turn leads to thermal runaway. It will be understood from the foregoing, however, that the vorticular flow provides an additional advantage of stability which permits relatively high flow rates.

In operation, a small amount of plasma-forming gas is first of all introduced into the reaction tube 30 via the gas inlet member 50. The microwave source 22 is then activated and a graphite lighting rod 140 temporarily inserted through the aperture located midway along the length of the reaction tube, as seen in Figure 1. The flow rate of the nitrogen plasma gas is then typically increased, and a body of plasma 80 is established which, at its broadest point, fills the reaction tube 30. Other methods of starting the plasma could of course be contemplated. Such as, but not limited to, employing a reduced pressure (around 30 mbar), at which pressure spontaneous ignition occurs, or using a pair of electrodes energised by a Tesla coil.

A plasma "jet" 90 extrudes through the exit nozzle 70 of the mixing zone 65. The nozzle 70 usually has a restricted outlet which increases the speed of the jet 90, although it is also possible for the outlet to be as wide as the full diameter of the reaction tube. This in turn reduces the dwell time in the gas phase of the activated species from the reactant fluid injected via the feedstock injection port 60.

The arrangement of Figures 1 and 2 permits relatively high plasma gas flow rates. Depending upon the inlet swirl and outlet, flow rates of up to 5000 litres per minute may be provided. Current applications (such as surface treatment and powder production), however, typically employ a flow rate of 40 litres/minute although higher rates are preferred for volatile organic compound (VOC) treatment. The stability, size and shape of the body of plasma 80, as well as the dimensions of the plasma jet 90, (all of which are a result of a variety of factors as explained above) are controlled by the power of the microwave source 22 and the flow rate of the plasma gas.

As to reactant fluids, typical flow rates of between about 0.5 litre/minute and 2 litres/minute have been found to be appropriate for injection of a liquid reactant, and here a suitable reservoir such as, for example, a Drechsel bottle is employed. The gaseous reactant fluids, by contrast, flow rates up to 3 litres/minute have been found particularly suitable, with a flow rate controlled by a mass flow controller. During operation, a considerable amount of heat is generated and a degree of cooling may optionally be provided by an enclosed aluminium water jacket (not shown in the Figures). Solid state deposits from the apparatus 10 can be collected either from around the nozzle 70, or alternatively downstream of the nozzle 70. In that case, either a filter arrangement can be employed to collect solid phase material downstream of the nozzle 70, or the jet 90 can be directed toward a substrate for deposition of solid phase materials onto that.

In yet a further alternative, a further processing chamber (not shown) may be provided downstream of the nozzle 70 as well. This allows control of the environment around the jet. The conditions in this further processing chamber also (in part) help to determine the plasma volume. Conditions within this further processing chamber can also be controlled: for example, it may be at a reduced pressure relative to the mixing zone 65, it might be supplied in the other gas types (e.g. helium), it may be injected with feedstock materials or may receive a further microwave or rf energy input.

The plasma flow out of the apparatus may also be manipulated: for example, in VOC work, it is possible to split off a stream from the incoming gas flow, divert it around the plasma, and then mix it with the emerging plasma jet in this further processing chamber below the nozzle 70.

One specific example of the use of the apparatus described above will now be provided.

### Example: Production of Carbon Black

The apparatus of Figures 1 and 2 has been found to be particularly suitable for the production of carbon black. Carbon black is a well-known substance formed of spheroidally-shaped particles grouped together into chains or clusters known as aggregates. Carbon black is formed by the dissociation of hydrocarbons and finds use as a filler for rubber products, in the manufacture of printing inks, tinting, and in paper and fibre colourings. Traditional methods for the production of carbon black (such as lamp black, furnace black and gas black) relied upon partial combustion of petrochemical and coal tar oils. Over recent decades, however, plasma systems have also been employed as they are typically more efficient and environmentally friendly. It is furthermore known that carbon blacks generated by a plasma process can have unique properties and characteristics. The apparatus of Figures 1 and 2, however, allows the production of carbon blacks having much more tightly controlled particle diameters than previously.

As set out in Table 1 below, nitrogen was employed as a plasma gas with microwave source 22 generating a power output of 2.77 kW. Various flow rates of plasma gas were employed, for two different reactant materials or feedstocks at a variety of different flow rates. Samples were collected from the nozzle 70, from within the jet 90, and downstream of the nozzle 70 using a bag filter.

**TABLE 1**

| APNEP Conditions | | | | | | | Elemental Analysis | | |
|---|---|---|---|---|---|---|---|---|---|
| Ref | Power (kW) | Plasma Gas | Flow Rate (l/min) | Feedstock | Feedstock Flow Rate (l/min) | Sample Collection | C (%) | H (%) | N (%) |
| A | 2.77 | N2 | 40 | Propane | 0.9 | Nozzle | 98.8 | <0.1 | <0.1 |
| B | 2.77 | N2 | 40 | Propane | 0.5 | Nozzle | 98.1 | <0.1 | <0.1 |
| C | 2.77 | N2 | 40 | Propane | 0.9 | Jet | 98.5 | <0.1 | <0.1 |
| D | 2.77 | N2 | 40 | Toluene | 2.0 | Bag filter | 97.9 | <0.1 | <0.1 |
| E | 3.68 | N2 | 24 | Toluene | 2.0 | Nozzle | 98.8 | <0.1 | <0.1 |
| F | 2.77 | N2 | 24 | Toluene | 2.0 | nozzle | 99.1 | <0.1 | 0.2 |
| G | 2.77 | N2 | 28 | Toluene | 2.0 | Bag Filter | 99.8 | <0.1 | 0.2 |
| H | 2.77 | N2 | 24 | Toluene | 2.0 | Bag Filter | 97.9 | <0.1 | <0.1 |
| I | 2.77 | N2 | 24 | Toluene | 2.5 | Bag Filter | 98.6 | <0.1 | <0.1 |
| J | 2.77 | N2 | 40 | Toluene | 2.5 | Bag filter | 98.6 | <0.1 | <0.1 |

In each case, the resultant particles were subjected to microanalysis and, in each case, were found to contain almost all carbon. Transmission electron microscopy (TEM) images were acquired of the carbon material prepared using the propane reactant, as set out in Table 2. Particle diameters were measured directly off the electron micrograph where it was possible to discern individual particles. The carbon material has a clear "grape-like" structure with a high degree of aggregate structure. Additionally, the majority of the particles within an aggregate are joined together, deforming their individual spherical shape into a fused chain of spheres. The narrow range of diameters of the particles is clearly seen from Table 2.

**TABLE 2**

| APNEP Conditions | | | | Particle Dimensions | |
|---|---|---|---|---|---|
| Power (kW) | Nitrogen Flow Rate (l/min) | Propane Flow Rate (l/min) | Sample Point | Mean Diameter (nm) | Range (nm) |
| 2.77 | 40 | 0.9 | Nozzle | 36 | 34-40 |
| 2.77 | 40 | 0.9 | Jet | 36 | 34-38 |

Contact angle measurements were made of both propane (C₃H₈) and toluene (C₇H₈) derived carbon blacks and the results are set out in Tables 3 and 4 below. Specific surface area measurements using various techniques are also shown for propane and toluene derived carbon blacks, in Tables 5 and 6 respectively.

**TABLE 3**

| APNEP Conditions | | | | Contact Angle Measurements | | | |
|---|---|---|---|---|---|---|---|
| Power (kW) | Nitrogen Flow Rate (l/min) | Propane Flow Rate (l/min) | Substate Distance (mm) | n | Mean angle (°) | Range (°) | σ (°) |
| 2.77 | 40 | 1.0 | 40 | 10 | 142.4 | 136.25-151.00 | 5.2 |
| 2.77 | 40 | 1.0 | 70 | 8 | 139.6 | 134.50-146.25 | 4.0 |
| 3.68 | 30 | 1.0 | 40 | 10 | 147.2 | 129.00-152.50 | 6.6 |

**TABLE 4**

| APNEP Conditions | | | | Contact Angle Measurements | | | |
|---|---|---|---|---|---|---|---|
| Power (kW) | Nitrogen Flow Rate (l/min) | Propane Flow Rate (l/min) | Substrate Distance (mm) | n | Mean angle (°) | Range (°) | σ (°) |
| 2.77 | 24 | 2.0 | 40 | 7 | 132.4 | 126.50-139.00 | 4.3 |
| 2.77 | 24 | 2.5 | 40 | 8 | 130.5 | 124.00-137.00 | 3.9 |
| 3.68 | 28 | 2.0 | 40 | 10 | 128.0 | 116.00-135.00 | 5.0 |

**Table 5**

| **Method** | **Data Set** | **Specific Surface Area (m²/g)** |
|---|---|---|
| BET | Nitrogen Absorption | 90.19 |
| BJH | Nitrogen Desorption | 82.81 |
| Porosimetry | Mercury | N/A |

**Table 6**

| **Method** | **Data Set** | **Specific Surface Area (m²/g)** |
|---|---|---|
| BET | Nitrogen Adsorption | 117.13 |
| BJH | Nitrogen Desorption | 116.90 |
| Porosimetry | Mercury | 232.30 |

Although a preferred embodiment has been described, it is to be understood that this is by way of example only and that various modifications and improvements may be employed. For example, although Figure 1 shows the apparatus with an exit nozzle 70 at the "bottom" of the reaction tube 30/mixing zone 65, it is possible to run the apparatus "upside down", that is, with the exit nozzle 70 at the top of the apparatus instead. This arrangement, which requires cooling of the flange surrounding the nozzle, has been employed for the treatment of carbon fibres, using a "bell-jar"-shaped vessel having a domed top. A small tube extends vertically upwards from the domed top and the plasma extends upwards through that tube. The tube itself is connected to a second horizontal tube to form a 'T'-junction and fibre passes along that horizontal tube where it is struck by the plasma at the confluence of the orthogonal tubes. Horizontal arrangements can also be employed.

The apparatus described above has many applications, such as cleaning and degreasing, destruction of VOCs, treatment of polymeric and carbon fibres, coating of glass, ceramics and polymers, surface modification of polymers, and production of powders. Modifications in the details of the apparatus may be appropriate, depending upon the specific application, but the underlying principles of plasma generation remain the same.

## Claims

1. A microwave plasma apparatus (10) comprising:
a microwave chamber (20) for containing gas and a plasma once initiated, the chamber (20) having an inlet and an outlet; a fluid inlet member (50) upstream of the microwave chamber inlet and in fluid communication therewith, the fluid inlet member (50) being adapted to alter the direction of flow of a received supply of gas so as to introduce the gas into the microwave chamber (20) via the inlet thereof as a vorticular or swirled flow;
and means (22) for radiating microwave energy into said chamber (20) to produce a plasma (80) therein, and being **characterised in that** the microwave chamber (20) and the means (22) for radiating microwave energy are adapted so as to establish a non-resonant, multimode microwave cavity (40).

2. The apparatus (10) of claim 1, in which the fluid inlet member (50) comprises one or more conduits (100) arranged to receive a supply of gas, and a curved section passage (110) in communication with the microwave chamber inlet, the or each conduit (100) having a longitudinal axis which is substantially perpendicular to a radius of the said curved section passage (110).

3. The apparatus (10) of claim 2, in which the said curved section passage (110) has a longitudinal axis, and wherein the longitudinal axis of the or each conduit (100) intersects a plane orthogonal to the longitudinal axis of the passage (110) at an angle between about 0° and about 30°.

4. The apparatus (10) of claim 3, in which the longitudinal axis of the or each conduit (100) intersects the plane orthogonal to the longitudinal axis of the passage (110) at an angle of 15°.

5. The apparatus (10) of any preceding claim, in which the microwave chamber (20) further includes a vessel (30) arranged to confine the plasma within a volume which is less than the total volume of the said microwave chamber (20).

6. The apparatus (10) of claim 5 when dependent upon claims 2, 3 or 4, in which the vessel (30) is substantially right cylindrical, and in which the curved section passage (110) in the fluid inlet member (50) is also substantially right cylindrical and substantially coaxial with the vessel (30) and the chamber inlet.

7. The apparatus (10) of claim 5 or claim 6, in which the vessel (30) is formed of a refractory material such as quartz.

8. The apparatus (10) of any preceding claim, in which the microwave chamber outlet is defined by a nozzle (70) adapted to cause a plasma gas within the chamber (20) to exit through the nozzle (70) as a jet (90).

9. The apparatus (10) of any of claims 1 to 7, further comprising a mixing chamber (65) located downstream of the microwave chamber (20) and in fluid communication therewith, the mixing chamber (65) being arranged to receive a plasma gas from the microwave chamber (20) via the outlet thereof, the mixing chamber (65) further comprising a reactant inlet (60) for introduction of reactant material into the said mixing chamber (65).

10. The apparatus (10) of claim 9, wherein the mixing chamber (65) has an exhaust port defined by a nozzle (70), the nozzle (70) being shaped so as to cause the plasma gas and any reactant material mixed therewith to exit via the nozzle (70) as a jet (90).

11. The apparatus (10) of any preceding claim, in which the means (22) for radiating the microwave energy into the chamber (20) comprises a variable power magnetron capable of generating up to 5kW of power.

12. The apparatus (10) of any preceding claim, in which the plasma can be generated in a volume of at least 250 cm³ and preferably around 800cm³.

13. The apparatus (10) of any preceding claim, further comprising means for generating a flow of the said gas which is arranged to generate a gas flow rate of at least 10 litres/minute and preferably up to 200 litres/minute; most preferably up to 5,000 litres/minute.

14. The apparatus (10) of any of claims 1 to 13, wherein the microwave chamber (20) is arranged to contain the gas at a pressure substantially at or above atmospheric pressure.

15. The apparatus (10) of any preceding claim, further comprising means (140) for initiating the plasma within the chamber.

16. A method of generating a plasma (80) in a microwave plasma apparatus (10) comprising:
introducing swirled or vorticular movement to a flow of gas; supplying the said vorticularly moving gas to a microwave chamber, (20) of the microwave plasma apparatus (10); and **characterised by** radiating microwave energy into the chamber (20) so as to establish a non-resonant multimodal microwave cavity in which the plasma (80) is produced.

17. The method of claim 16, in which the flow of gas is supplied to the chamber (20) at a flow rate of at least 10 litres/minute, preferably up to 200 litres/minute, and most preferably up to 5,000 litres/minute.

18. The method of claim 16 or 17, in which the microwave energy is radiated at a power of at least 1 kW and preferably up to 5kW.

19. The method of any of claims 16, 17 or 18, further comprising supplying a reactant material to the plasma (80).

20. The method of claim 19, in which the step of supplying a reactant material to the plasma (80) comprises supplying a hydrocarbon material thereto.

21. The method of claim 19 or claim 20, further comprising supplying the reactant material to a mixing chamber (65) downstream of the microwave chamber (20) for reaction with the plasma (80) in the said mixing chamber (65).

22. The method of any of claims 16 to 21, further comprising containing the gas in the chamber (20) substantially at or above atmospheric pressure.

23. The method of any of claims 16 to 22, further comprising initiating the plasma (80) in the chamber (20).

## Patentansprüche

1. Mikrowellenplasmavorrichtung (10), umfassend:
eine Mikrowellenkammer (20) zum Enthalten von Gas und einem Plasma auf ein Initiieren hin, wobei die Kammer (20) einen Einlass und einen Auslass aufweist;
ein Fluideinlasselement (50) stromaufwärts von dem Mikrowellenkammereinlass, das in Fluidverbindung damit steht, wobei das Fluideinlasselement (50) dazu angepasst ist, die Richtung des Stroms einer empfangenen Zufuhr von Gas zu verändern, um das Gas in die Mikrowellenkammer (20) über den Einlass davon als einen Strudel- oder Wirbelstrom einzuführen;
und Mittel (22) zum Abstrahlen von Mikrowellenenergie in die Kammer (20), um ein Plasma (80) darin zu erzeugen, und
**dadurch gekennzeichnet, dass** die Mikrowellenkammer (20) und die Mittel (22) zum Abstrahlen von Mikrowellenenergie dazu angepasst sind, eine nicht-resonante, Multimoden-Mikrowellenkavität (40) zu bilden.

2. Vorrichtung (10) nach Anspruch 1, wobei das Fluideinlasselement (50) eine oder mehr Leitungen (100), die dazu angeordnet sind, eine Zufuhr von Gas zu empfangen, und einen gekrümmten Abschnittsdurchgang (110) umfasst, der in Verbindung mit dem Mikrowellehkammereinlass steht, wobei die oder jede Leitung (100) eine Längsachse aufweist, die im Wesentlichen senkrecht zu einem Radius des gekrümmten Abschnittsdurchgangs (110) ist.

3. Vorrichtung (10) nach Anspruch 2, wobei der gekrümmte Abschnittsdurchgang (110) eine Längsachse aufweist, und wobei die Längsachse der oder jeder Leitung (100) eine Ebene, die orthogonal zu der Längsachse des Durchgangs (110) ist, mit einem Winkel von zwischen etwa 0° und etwa 30° schneidet.

4. Vorrichtung (10) nach Anspruch 3, wobei die Längsachse der oder jeder Leitung (100) die Ebene, die orthogonal zu der Längsachse des Durchgangs (110) ist, mit einem Winkel von 15° schneidet.

5. Vorrichtung (10) nach einem der vorhergehenden Ansprüche, wobei die Mikrowellenkammer (20) ferner ein Behältnis (30) umfasst, das dazu angeordnet ist, das Plasma in einem Volumen zu begrenzen, das kleiner als das Gesamtvolumen der Mikrowellenkammer (20) ist.

6. Vorrichtung (10) nach Anspruch 5 unter Einbeziehung von einem der Ansprüche 2, 3 oder 4, wobei das Behältnis (30) im Wesentlichen geradzylindrisch ist und wobei der gekrümmte Abschnittsdurchgang (110) in dem Fluideinlasselement (50) auch im Wesentlichen geradzylindrisch und im Wesentlichen koaxial mit dem Behältnis (30) und dem Kammereinlass ist.

7. Vorrichtung (10) nach Anspruch 5 oder 6, wobei das Behältnis (30) aus einem hitzebeständigen Material, wie beispielsweise Quarz, gebildet ist.

8. Vorrichtung (10) nach einem der vorhergehenden Ansprüche, wobei der Mikrowellenkammerauslass durch eine Düse (70) definiert ist, die dazu angepasst ist, ein Plasmagas in der Kammer (20) dazu zu veranlassen, durch die Düse (70) als ein Strahl (90) auszutreten.

9. Vorrichtung (10) nach einem der Ansprüche 1 bis 7, ferner umfassend eine Mischkammer (65), die sich stromabwärts von der Mikrowellenkammer (20) befindet und in Fluidverbindung damit steht, wobei die Mischkammer (65) dazu angeordnet ist, ein Plasmagas von der Mikrowellenkammer (20) durch den Auslass davon zu empfangen, wobei die Mischkammer (65) ferner einen Reaktand-Einlass (60) zum Einführen von Reaktand-Material in die Mischkammer (65) umfasst.

10. Vorrichtung (10) nach Anspruch 9, wobei die Mischkammer (65) einen Auslassanschluss aufweist, der durch eine Düse (70) definiert ist, wobei die Düse (70) so geformt ist, dass das Plasmagas und jedes damit vermischte Reaktand-Material dazu veranlasst werden, durch die Düse (70) als ein Strahl (90) auszutreten.

11. Vorrichtung (10) nach einem der vorhergehenden Ansprüche, wobei die Mittel (22) zum Abstrahlen der Mikrowellenenergie in die Kammer (20) ein Magnetron variabler Leistung umfassen, das dazu geeignet ist, eine Leistung von bis zu 5 kW zu generieren.

12. Vorrichtung (10) nach einem der vorhergehenden Ansprüche, wobei das Plasma in einem Volumen von wenigstens 250 cm³ und von vorzugsweise etwa 800 cm³ erzeugt werden kann.

13. Vorrichtung (10) nach einem der vorhergehenden Ansprüche, ferner umfassend Mittel zum Erzeugen eines Stroms des Gases, die dazu angeordnet sind, eine Gasstromrate von wenigstens 10 Litern pro Minute und von vorzugsweise bis zu 200 Litern pro Minute, am bevorzugtesten von bis zu 5000 Litern pro Minute, zu erzeugen.

14. Vorrichtung (10) nach einem der Ansprüche 1 bis 13, wobei die Mikrowellenkammer (20) dazu angeordnet ist, das Gas bei einem Druck von im Wesentlichen Atmosphärendruck oder größer als Atmosphärendruck zu enthalten.

15. Vorrichtung (10) nach einem der vorhergehenden Ansprüche, ferner umfassend Mittel (140) zum Iniitieren des Plasmas in der Kammer.

16. Verfahren zum Erzeugen eines Plasmas (80) in einer Mikrowellenplasmavorrichtung (10), umfassend:
Einleiten einer Wirbel- oder Strudelbewegung in einem Strom von Gas;
Zuführen des eine Strudelbewegung ausführenden Gases in eine Mikrowellenkammer (20) der Mikrowellenplasmavorrichtung (10); und
**gekennzeichnet durch** Abstrahlen von Mikrowellenenergie in die Kammer (20), um eine nicht-resonante Multimoden-Mikrowellenkavität zu bilden, in der das Plasma (80) erzeugt wird.

17. Verfahren nach Anspruch 16, wobei der Strom von Gas der Kammer (20) mit einer Stromrate von wenigstens 10 Litern pro Minute, von vorzugsweise bis zu 200 Litern pro Minute, und am bevorzugtesten von bis zu 5000 Litern pro Minute zugeführt wird.

18. Verfahren nach Anspruch 16 oder 17, wobei die Mikrowellenenergie mit einer Leistung von wenigstens 1 kW und vorzugsweise bis zu 5 kW abgestrahlt wird.

19. Verfahren nach einem der Ansprüche 16, 17 oder 18, ferner umfassend, dass ein Reaktand-Material dem Plasma (80) zugeführt wird.

20. Verfahren nach Anspruch 19, wobei der Schritt des Zuführens eines Reaktand-Materials zu dem Plasma (80) umfasst, dass diesem ein Kohlenwasserstoff-Material zugeführt wird.

21. Verfahren nach Anspruch 19 oder 20, ferner umfassend, dass das Reaktand-Material einer Mischkammer (65) stromabwärts von der Mikrowellenkammer (20) zur Reaktion mit dem Plasma (80) in der Mischkammer (65) zugeführt wird.

22. Verfahren nach einem der Ansprüche 16 bis 21, ferner umfassend, dass das Gas in der Kammer (20) bei einem Druck enthalten ist, der im Wesentlichen so groß wie oder größer als Atmosphärendruck ist.

23. Verfahren nach einem der Ansprüche 16 bis 22, ferner umfassend, dass das Plasma (80) in der Kammer (20) initiiert wird.

## Revendications

1. Appareil à plasma microondes (10) comprenant :
une chambre à microondes (20) pour contenir du gaz et un plasma une fois initié, la chambre (20) ayant une entrée et une sortie ; une chambre d'entrée de fluide (50) en amont de l'entrée de la chambre à microondes et en communication fluidique avec celle-ci, la chambre d'entrée de fluide (50) étant adaptée pour changer la direction d'écoulement d'une alimentation de gaz reçue de sorte à introduire le gaz dans la chambre à microondes (20) à travers son entrée sous forme d'un écoulement turbulent ou tourbillonnant ;
et un moyen (22) destiné à irradier de l'énergie microondes dans ladite chambre (20) afin d'y produire un plasma (80) et étant **caractérisé en ce que** la chambre à microondes (20) et le moyen (22) pour irradier de l'énergie microondes sont adaptés pour établir une cavité microondes non-résonante multi-modes (40).

2. Appareil (10) de la revendication 1, dans lequel l'élément d'entrée fluidique (50) comprend un ou plusieurs conduits (100) agencés pour recevoir une alimentation de gaz, et un passage à section courbée (110) en communication avec l'entrée de chambre à microondes, le ou chaque conduit (100) ayant un axe longitudinal qui est essentiellement perpendiculaire à un rayon dudit passage à section courbée (110).

3. Appareil (10) de la revendication 2, dans lequel ledit passage à section courbée (110) a un axe longitudinal, et dans lequel l'axe longitudinal du ou de chaque conduit (100) présente une intersection avec un plan orthogonal à l'axe longitudinal du passage (110) à un angle entre environ 0° et environ 30°.

4. Appareil (10) de la revendication 3, dans lequel l'axe longitudinal du ou de chaque conduit (100) présente une intersection avec le plan orthogonal à l'axe longitudinal du passage (110) à un angle de 15°.

5. Appareil (10) de l'une des revendications précédentes, dans lequel la chambre à microondes (20) comporte en plus une cuve pour confiner le plasma dans un volume qui est inférieur au volume total de ladite chambre à microondes (20).

6. Appareil (10) de la revendication 5 lorsqu'elle dépend des revendications 2, 3 ou 4, dans lequel la cuve (30) est essentiellement cylindrique droit, et dans lequel le passage à section courbée (110) dans la chambre d'entrée de fluide (50) est également essentiellement cylindrique droit et essentiellement coaxial avec la cuve (30) et l'entrée de la chambre.

7. Appareil (10) de la revendication 5 ou 6, dans lequel la cuve (30) est formée d'un matériau réfractaire tel que du quartz.

8. Appareil (10) de l'une des revendications précédentes, dans lequel la sortie de la chambre à microondes est définie par une buse (70) adaptée pour amener un gaz plasma se trouvant dans la chambre (20) à sortir à travers la buse (70) sous forme de jet (90).

9. Appareil (10) de l'une des revendications 1 à 7, comprenant en plus une chambre de mélange (65) située en aval de la chambre à microondes (20) et en communication fluidique avec celle-ci, la chambre de mélange (65) étant agencée pour recevoir un gaz plasma de la chambre à microondes (20) à travers sa sortie, la chambre de mélange (65) comprenant en plus une entrée réactive (60) pour introduire un matériau réactif dans ladite chambre de mélange (65).

10. Appareil (10) de la revendication 9, dans lequel la chambre de mélange (65) a un orifice d'échappement défini par une buse (70), la buse (70) étant conformée de sorte à amener le gaz plasma et tout matériau réactif mélangé avec celui-ci à sortir à travers la buse (70) sous forme de jet (90).

11. Appareil (10) de l'une des revendications précédentes, dans lequel le moyen (22) pour irradier l'énergie microondes dans la chambre (20) comprend un magnétron capable de générer jusqu'à 5kW de puissance.

12. Appareil (10) de l'une des revendications précédentes, dans lequel le plasma peut être généré dans un volume d'au moins 250 cm³ et préférablement autour de 800 cm³.

13. Appareil (10) de l'une des revendications précédentes, comprenant en plus un moyen pour générer un écoulement dudit gaz qui est agencé pour générer un débit de gaz d'au moins 10 litres/minute et préférablement jusqu'à 200 litres/minute ; plus préférablement jusqu'à 5000 litres/minute.

14. Appareil (10) de l'une des revendications 1 à 13, dans lequel la chambre à microondes (20) est agencée pour contenir le gaz à une pression essentiellement égale ou supérieure à la pression atmosphérique.

15. Appareil (10) de l'une des revendications précédentes, comprenant en plus un moyen (140) pour initier le plasma dans la chambre.

16. Procédé de génération d'un plasma (80) dans un appareil à plasma microondes (10) comprenant le fait :
d'introduire un mouvement tourbillonnant ou turbulent à un écoulement de gaz ; d'alimenter ledit gaz en écoulement turbulent à une chambre à microondes (20) de l'appareil à plasma microondes (10) ; et **caractérisé par** le fait d'irradier de l'énergie microondes dans la chambre (20) de sorte à établir une cavité microondes multimodale non-résonante dans laquelle le plasma (80) est produit.

17. Procédé de la revendication 16, dans lequel l'écoulement de gaz est alimenté à la chambre (20) à un débit d'au moins 10 litres/minute, préférablement jusqu'à 200 litres/minute, et plus préférablement jusqu'à 5000 litres/minute.

18. Procédé de la revendication 16 ou 17, dans lequel l'énergie microondes est irradiée à une puissance d'au moins 1kW et préférablement jusqu'à 5kW.

19. Procédé de l'une des revendications 16, 17 ou 18, comprenant en plus l'alimentation d'un matériau réactif au plasma (80).

20. Procédé de la revendication 19, dans lequel l'étape d'alimentation d'un matériau réactif au plasma (80) comprend l'alimentation d'une matière hydrocarbonée à celui-ci.

21. Procédé de la revendication 19 ou 20, comprenant en plus l'alimentation du matériau réactif à une chambre de mélange (65) en aval de la chambre à microondes (20) pour réagir avec le plasma (80) dans ladite chambre de mélange.

22. Procédé de l'une des revendications 16 à 21, comprenant en plus le fait de contenir le gaz dans la chambre (20) essentiellement à ou au-dessus de la pression atmosphérique.

23. Procédé de l'une des revendications 16 à 22, comprenant en plus le fait d'initier le plasma (80) dans la chambre (20).
